# EUROPEAN PATENT APPLICATION

(11) **EP 2 360 601 A1**
(43) Date of publication of application: **24.08.2011**
(21) Application number: 10153725.6
(22) Date of filing: 16.02.2010
(51) Int. Cl.: G06F 15/78, H03K 19/177

(54) **Programmable logic device with custom blocks**

(71) Applicant: Panasonic Corporation, Kadoma-shi Osaka 571-8501 (JP)
(72) Inventor: Olgiati, Andrea, Bristol, Bristol BS1 6EA (GB); Stansfield, Tony, Bristol, Bristol BS1 6EA (GB); Deeley, Simon, Bristol, Bristol BS1 6EA (GB)
(74) Representative: Haley, Stephen

(57) **Abstract**

A programmable logic device is described, comprising a uniform routing network, an array of user programmable tiles connected to the uniform routing network and at least one functional block arranged to span at least one tile and further arranged to be connected to the uniform routing network.

## Description

The present invention relates to the field of user programmable logic devices (PLDs). More specifically, the present invention is directed to a reconfigurable logic device having custom, embedded application-specific functional blocks.

Reconfigurable devices/fabrics, such as D-Fabrix (disclosed in, for example, US6353841, US6252792, US2002/0157066) are commonly made up of a plurality of interconnected user programmable logic blocks or tiles, the fundamental building blocks of the system. This arrangement facilitates the use of an easily scalable configuration mechanism of equally regular structure.

Each user programmable tile is connected to a programmable routing network which can implement arbitrary connectivity between the tiles. Because each tile is connected to the routing network in the same way, the resulting device has a high degree of homogeneity. That is to say that, the way in which a specific subset of tiles of an array can be used and interconnected will be the same, regardless of where on the array that subset is located. Such a homogeneous array can be found disclosed in, for example, US6252792.

The use of application-specific functional blocks in conjunction with a reconfigurable device/fabric is a known way of enhancing the performance of the device/fabric within specific application contexts. For example, a reconfigurable logic array can be used in conjunction with Random Access Memory (RAM) blocks and Digital Signal Processors (DSP) blocks.

Prior art methods of using these application-specific functional blocks have included the insertion of the blocks within the array in ways that led to modifications of the routing networks, creating a non-homogeneous structure. In one such embodiment, the array of programmable logic tiles is split at a specific point (e.g. along a row or column of logic tiles), thereby creating a gap in the fabric. The application-specific functional block is then inserted in that gap.

This method hinders or precludes direct connections between tiles on either side of the gap. These tiles on either side of the gap are typically connected directly to the application specific functional block and, in some cases also connected to the dedicated switches which allow the possibility of further connections to the tiles located on the other far side of the application-specific functional block.

Such gaps therefore create a significant disruption to the routing network, which will cause a decrease in the homogeneity of the array. As a result, a greater degree of care must be taken during fabrication of the device itself, as the structure of the programmable logic device is no longer regular. Moreover, the placement and routing phases of application mapping are made more difficult, as these disruptions to the homogeneity of the array of programmable logic tiles will pose extra constraints on where specific elements of a design can be placed on the array (placement), as well as how those elements can be connected to other parts of the array/circuit (routing).

There is therefore a clear need for a novel method of embedding an application specific functional block in a reconfigurable array of programmable logic tiles.

In order to solve the problems associated with the prior art, the present invention provides a programmable logic device which comprises:
a uniform routing network;
an array of user programmable tiles connected to the uniform routing network; and
at least one functional block arranged to span at least one tile and further arranged to be connected to the uniform routing network.

Preferably, each tile comprises a plurality of processing units and the same number of associated routing sections; and
the at least one functional block is arranged to physically replace at least one of the processing units of at least one tile.

Preferably, the uniform routing network comprises a grid of uniformly distributed multi-bit buses, the grid comprising a first plurality of parallel buses and a second plurality of parallel buses, the first plurality being substantially perpendicular to the second plurality; and
each routing section comprises a plurality of switches, each switch being arranged to selectively connect a bus from the first plurality of parallel buses to a bus of the second plurality of parallel buses.

Preferably, a plurality of the switches in each routing section are arranged to connect the routing section to its associated processing unit; and
a plurality of the switches in each routing section are arranged to connect the routing section to other routing sections.

Preferably, the at least one of the switches in the plurality of routing sections of a tile having at least one of its processing units replaced by the at least one functional block is used to connect at least one of an input or an output of the at least one functional block to the uniform routing network.

Preferably, each switch in each routing section comprises a driver for driving an electrical signal to one of a processing unit, a routing section or a functional block.

Preferably, the strength of the driver is a function of the distance between the driver and the one of a processing unit, a routing section or a functional block.

Preferably, the multi-bit buses are four-bit buses.

As will be appreciated, the present invention provides several advantages over the prior art. For example, the present invention allows the substitution of an arbitrary number of logic tiles, whereas prior art solutions only allow the substitution of a fixed number of positions. Moreover, because the overall routing architecture is not disrupted, it is easier to predict delays and routability. Furthermore, activities related to the fabrication of the device (layout, verification, manufacturing test, etc) are made significantly simpler, as the routing network patterns can be considered identical for all tiles.

Specific embodiments of the invention will now be described with reference to the accompanying drawings, in which:
Figure 1 represents a reconfigurable device/fabric made up of a plurality of user programmable logic tiles;
Figure 2 represents a closer view of the reconfigurable device of Figure 1, including Arithmetic Logic Units and switch boxes;
Figure 3 represents a prior art method of embedding an application specific functional block in an array of user programmable logic tiles;
Figure 4 represents a schematic diagram of the connectivity required for a device fabricated in accordance with the method of Figure 3;
Figure 5 represent a reconfigurable logic device in accordance with one embodiment of the present invention;
Figure 6 represents a closer view of an embedded application specific functional block in accordance with one embodiment of the present invention;
Figure 7 represents a closer view of another embodiment of an embedded application specific functional block in accordance with the present invention; and

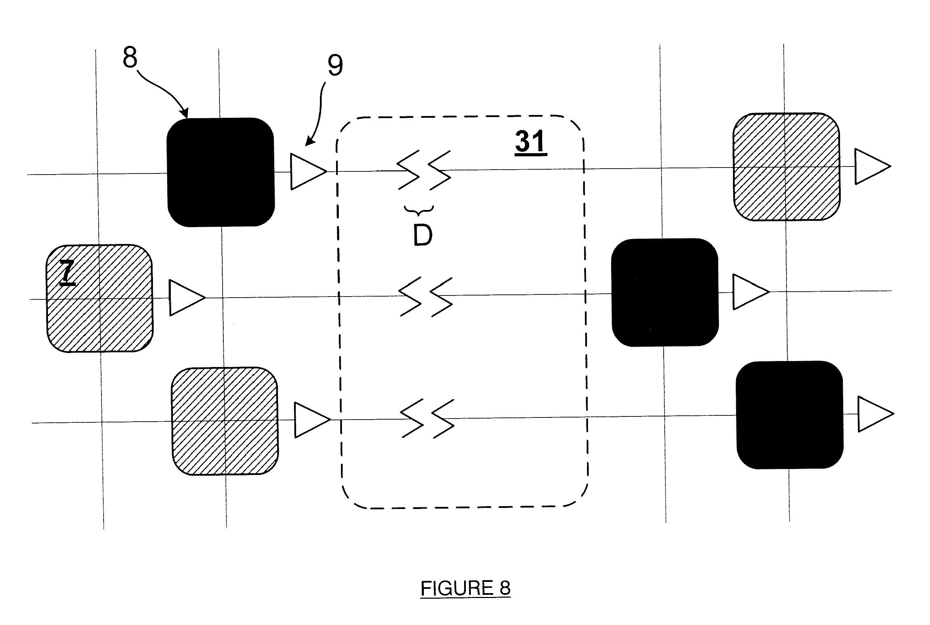

Figure 8 represents a view of specific switches in accordance with the embodiments shown in Figure 6 and Figure 7.

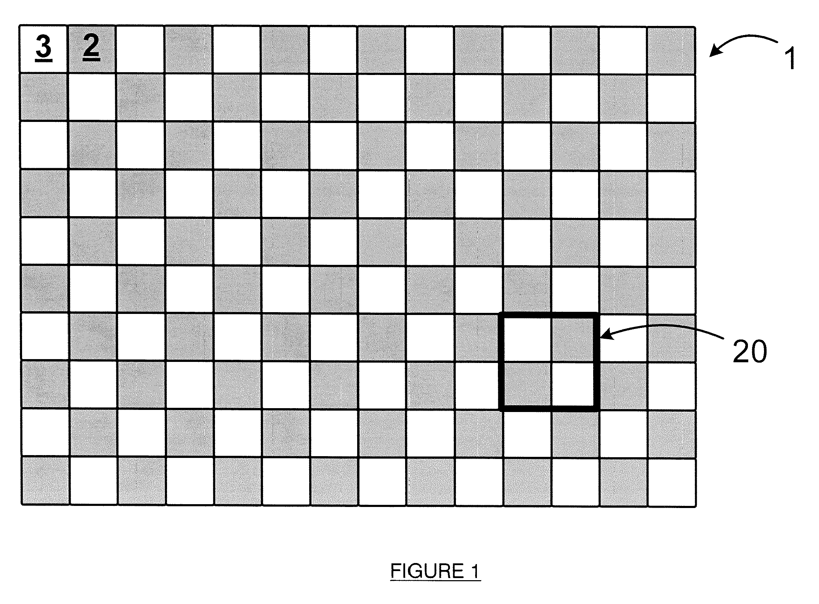

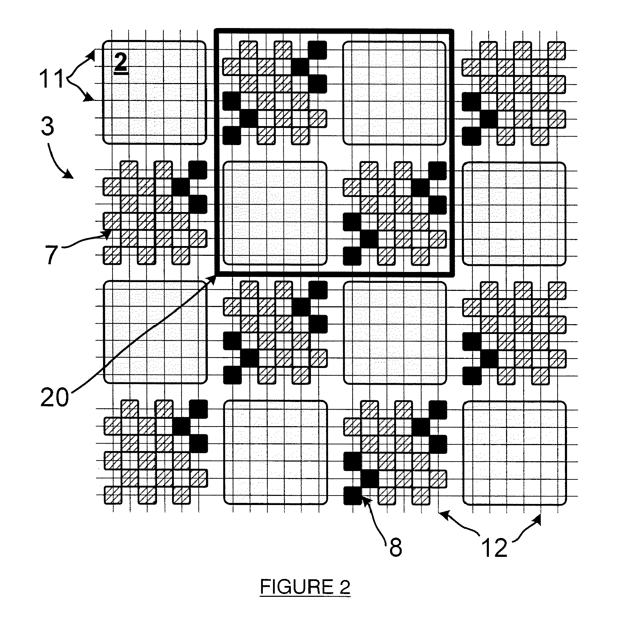

Figure 1 shows a diagram representing a programmable fabric 1 comprising a plurality of Arithmetic Logic Units (ALUs) 2 interconnected by way of a plurality of switching sections 3. As shown in Figure 1, each tile 20 is divided into four areas. A two-by-two group of ALUs 2 and switching sections 3 forms a tile 20, which is the basic building block of the fabric, and is shown bounded by a thick line in Figures 1 and 2. Two of the areas, which are diagonally opposed in the tile 20, provide locations for a pair of ALUs 2. The other two circuit areas, which are also diagonally opposed in the tile, provide the locations for a pair of switchboxes 3.

Each ALU can perform standard arithmetic operations (such as ADD, SUBTRACT) as well as standard logic operations (such as AND, NAND, OR, NOR) on a set number of bits.

Figure 2 shows a closer view of the fabric 1. Each tile 20 contains two ALUs 2 and two switching sections 3. Each switching section 3 comprises a plurality of switches 7 which are each arranged to selectively connect a horizontal bus 11 to a vertical bus 12 at their intersection point. The horizontal and vertical buses can be any number of bits wide. Some switches 8, which are shown as black squares in Figure 2, are used for locally connecting the ALUs 2 to the switching sections 3. Other switches 7, which are shown as striped squares in Figure 2, are used for longer distance connections (e.g. between switch sections 3).

As can be seen from Figure 1 and Figure 2, the fabric 1 has a high degree of homogeneity in that a particular tile can be used (i.e. configured or interconnected) in the exact same way as every other tile in the array.

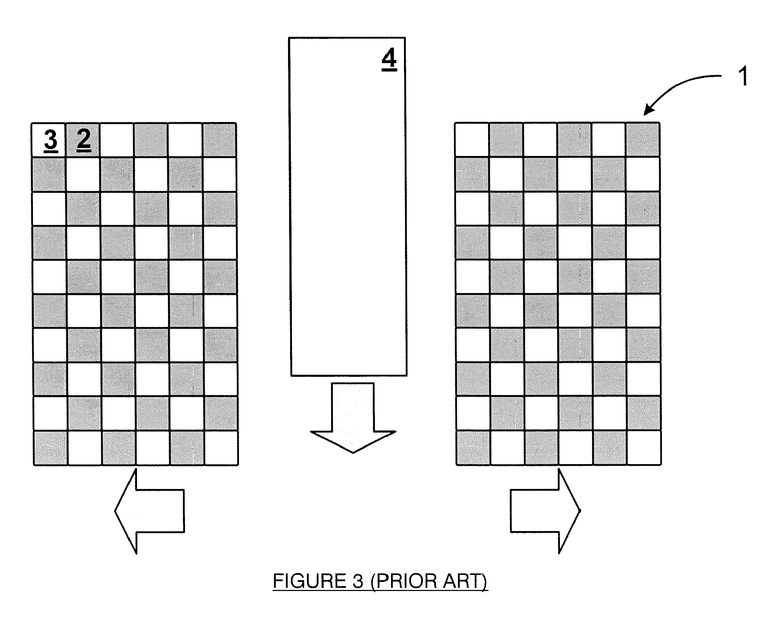

Figure 3 is a representation of a prior art method of embedding an application specific functional block 4 into reconfigurable fabric 1. Application-specific functional blocks can consist of several different types of circuits, for example Random Access Memory (RAM) blocks and Digital Signal Processors (DSP) blocks. As will be appreciated, in order to insure that the array 1 can operate in conjunction with the embedded application-specific functional block 4, certain connections need to exist between functional block 4 and ALUs 2.

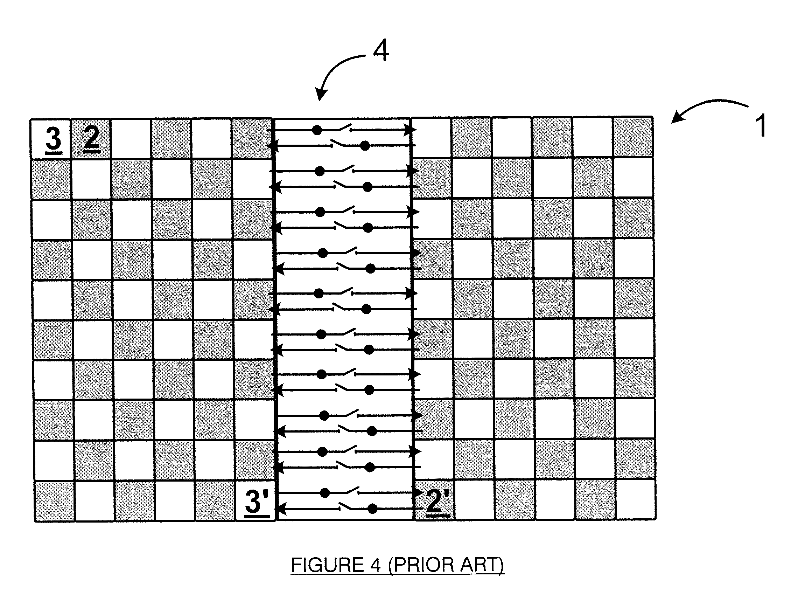

Figure 4 shows an example of how an application-specific functional block 4, which has been embedded in accordance with the method of Figure 3, can be connected to the array 1. In Figure 4, the ALU 2' has an outgoing connection to both the application specific functional block 4 and to the switching section 3'. Similarly, switching section 3' has an outgoing connection to both the application specific functional block 4 and to the ALU 2'. As will be appreciated, the above mentioned outgoing connection can pass through other dedicated switching elements. Accordingly, in order to connect the columns of tiles on either side of the application-specific functional block 4 to each other, it is necessary to create a dedicated switching circuit. Moreover, these connections are mutually exclusive. That is to say that switching section 3' can either be connected to ALU 2' or to application specific functional block 4 at any given time. Accordingly, if switching section 3' is connected to ALU 2', it will not be possible to use functional block 4.

The significant disadvantage associated with this technique is that the dedicated switching circuit modifies the pattern of the routing network of the array, and must therefore be taken into consideration when trying to predict routing delays. The homogeneity of the routing network is therefore significantly disrupted.

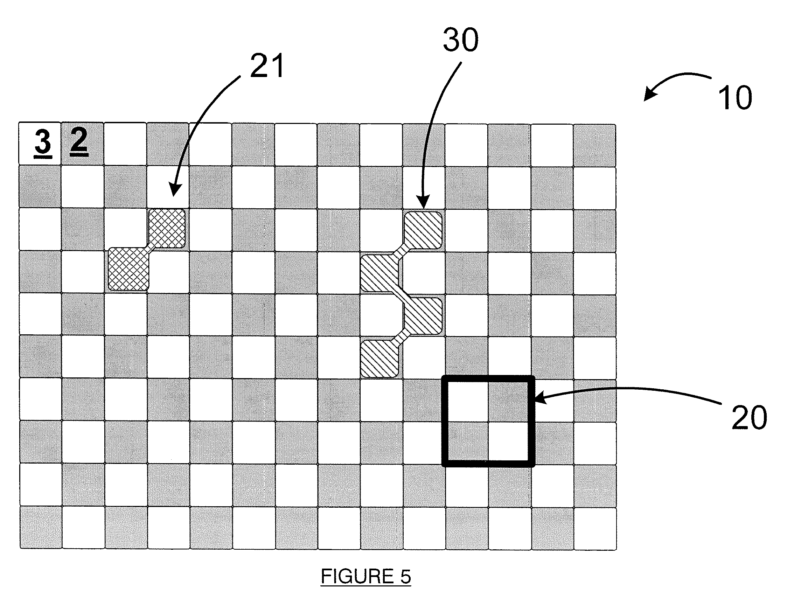

Figure 5 represents a reconfigurable fabric 10 which comprises custom, embedded application-specific functional blocks 21, 30. These custom, embedded application-specific functional blocks 21, 30 are disposed in such a way that they replace ALUs 2 in the fabric. Custom block 21 replaces two, diagonally disposed ALUs 2 (spanning a tile 20) and custom block 30 replaces a chain of four diagonally disposed ALUs 2 (spanning two tiles 20). In the embodiment of Figure 5, custom blocks 21 and 30 have the same footprint as the ALUs 2 of the tiles 20 which they replace, though this is not necessarily the case.

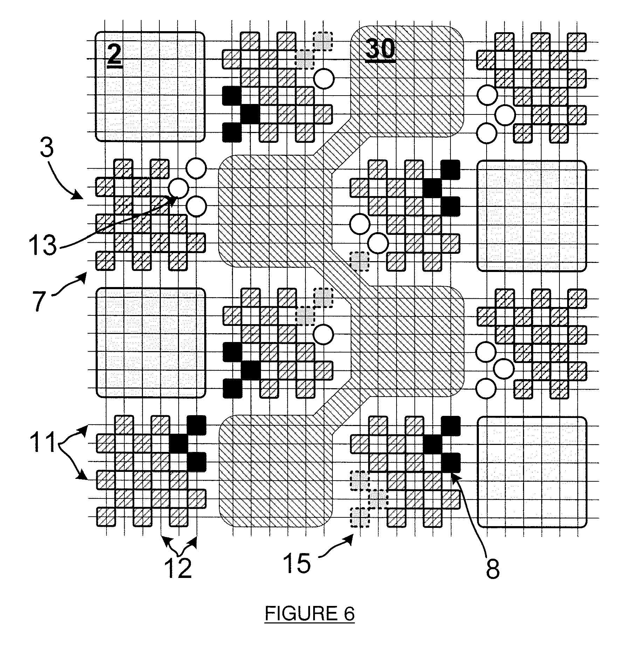

Figure 6 shows a more detailed view of the custom block 30. In this embodiment, each switching section 3 comprises a plurality of switches 7 which are again each arranged to selectively connect a horizontal bus 11 to a vertical bus 12 at their intersection point. Some switches 8, which are shown as black squares in Figure 6, are used for locally connecting the ALUs 2 to the switching sections 3. Other switches 7, which are shown as striped squares in Figure 6, are used for longer distance connections (e.g. between switch sections 3). Finally, switches 15, which are shown as broken lined squares in Figure 6, are used to connect the switching sections 3 to the custom block 30.

Although switches 15 and 8 appear different in the figures, it will be appreciated that these switches are similar in terms of function. As will also be appreciated, not all of the switches 15 which are adjacent to the custom block 30 are used to connect the switching sections to the custom block. Some of the switches can simply not be used. The unused switches 13 are shown in Figure 6 as opaque white circles.

When ALUs 2 are replaced with custom block 30, the switches 8 which were used to connect the routing network to the ALUs 2 will either be used as a switch 15 to connect the custom block 30 to the routing network or will be an unused switch 13. The switches 7 however will remain unchanged.

In the embodiment of Figure 6, the custom block 30 uses eight switches from four different switching sections 3 in order to connect to the routing network. In this embodiment, the custom block 30 could have, for example, four 4-bit inputs and four 4-bit outputs, each of the inputs and outputs being connected to a switch 15. The custom block is therefore replacing four ALUs 2 in the fabric and using a part of the resources which would have otherwise been used by those same ALUs 2. As is clear from Figure 6 however, whilst the insertion of an application-specific functional block 30 has decreased the number of ALUs 2 which can be used in the array, it has not affected the repetitive structure of the routing network.

Accordingly, if a signal needs to be routed from one side of the application specific functional block 30 to the other side, it will not be necessary for a router to incorporate information related to the presence of application specific functional block 30 while trying to connect unrelated blocks. Furthermore, for the same router, it will not be necessary to incorporate delay information relating to a dedicated, external switching circuit, provided that the custom block 30 sits within the same physical footprint as the ALUs it replaces. In effect, the application specific functional block will become invisible to a router for the purposes of connecting signals across it, or calculating delays.

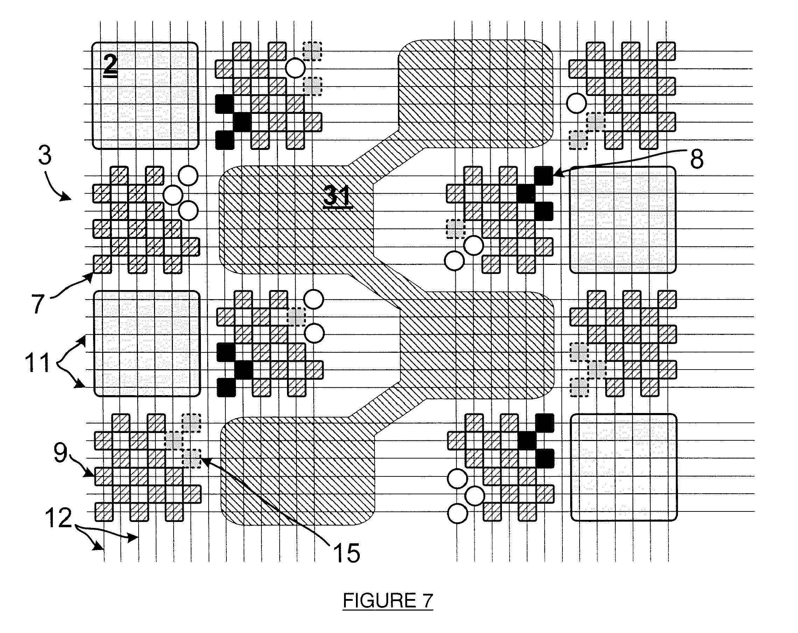

A second embodiment of the present invention is shown in Figure 7. In this embodiment, each switching section 3 comprises a plurality of switches 7, 8, 9 which are again each arranged to selectively connect a horizontal bus 11 to a vertical bus 12 at their intersection point. Some switches 8, which are shown as black squares in Figure 7, are used for locally connecting the ALUs 2 to the switching sections 3. Other switches 7, which are shown as striped squares in Figure 7, are used for longer distance connections (e.g. between switch sections 3). Finally, switches 15, which are shown as broken lined squares in Figure 7, are used to connect the switching sections 3 to the custom block 31. As is the case with the previous embodiment, not all of the switches 15, 8 which are adjacent to the custom block 31 are used to connect the switching sections to the custom block. Some of these switches 13 can simply not be used. Unused switches are shown as opaque white circles in Figure 6.

In the embodiment of Figure 7, the custom block 31 uses twelve switches from six different switching sections 3 in order to connect to the routing network. Thus, in this embodiment, the custom block 31 could have, for example, four 4-bit inputs and eight 4-bit outputs, each of the inputs and outputs being connected to a switch 15. As is clear from Figure 7, whilst the insertion of an application-specific functional block 31 has decreased the number of ALUs 2 which can be used in the array, it has not affected the repetitive structure of the routing network.

The physical size of the custom block 31 of the embodiment of Figure 7 is significantly larger than the size of the custom block 30 shown in Figure 6. The distance that a signal must travel between opposite sides of custom 31 is therefore larger than the distance which a signal must travel between opposite sides of custom block 30. In order for this distance not to affect delay calculations, the drivers 9 used to propagate signals from one side of custom block 31 will need to be stronger than the same drivers used in the embodiment of Figure 6. It can therefore be seen that the size of the driver 9 needed to propagate a signal from one side of a custom block 30, 31 to the other will be a function of the distance that a signal must travel across the custom block 30, 31.

Accordingly, if a signal needs to be routed from one side of the application specific functional block 30 to the other side, it will not be necessary for a router to incorporate delay information relating to a dedicated, external switching circuit, provided that, if the size of the custom block exceeds the footprint of the ALUs it replaces, the switches on either side of the custom block 31 have drivers which are arranged to decrease the delay across the custom block 31 to a level similar to the delay between similar switches on either side of an ALU 2 in the fabric.

Whilst, in the embodiment of Figure 7, the custom block exceeds the combined footprint of the ALUs which it replaces, it can be seen that the topology of the routing network has not been disrupted. Thus, as is the case with the embodiment of Figure 6, the application specific functional block 31 will become invisible to a router for the purposes of calculating delays.

As can be understood from the embodiments described above, any number of ALUs which are replaced by a custom block 30, 31 in accordance with the present invention will depend on the number of inputs and outputs that the particular block 30, 31 must have connected to the routing network. Moreover, the blocks themselves can be of any dimension, provided that any added delay relating to the difference in the distance between switches on either side of the custom block 30, 31, and the distance between any two adjoining tiles 20 in the fabric 1 is compensated for by the addition of more powerful drivers on either side of the custom blocks 30, 31.

## Claims

1. A programmable logic device comprising:
a uniform routing network;
an array of user programmable tiles connected to the uniform routing network; and
at least one functional block arranged to span at least one tile and further arranged to be connected to the uniform routing network.

2. The programmable logic device of claim 1, wherein:
each tile comprises a plurality of processing units and the same number of associated routing sections; and
the at least one functional block is arranged to physically replace at least one of the processing units of at least one tile.

3. The programmable logic device of claim 2, wherein:
the uniform routing network comprises a grid of uniformly distributed multi-bit buses, the grid comprising a first plurality of parallel buses and a second plurality of parallel buses, the first plurality being substantially perpendicular to the second plurality; and
each routing section comprises a plurality of switches, each switch being arranged to selectively connect a bus from the first plurality of parallel buses to a bus of the second plurality of parallel buses.

4. The programmable logic device of claim 3, wherein:
a plurality of the switches in each routing section are arranged to connect the routing section to its associated processing unit; and
a plurality of the switches in each routing section are arranged to connect the routing section to other routing sections.

5. The programmable logic device of claim 4, wherein:
at least one of the switches in the plurality of routing sections of a tile having at least one of its processing units replaced by the at least one functional block is used to connect at least one of an input or an output of the at least one functional block to the uniform routing network.

6. The programmable logic device of claim 5, wherein each switch in each routing section comprises a driver for driving an electrical signal to one of a processing unit, a routing section or a functional block.

7. The programmable logic device of claim 6, wherein the strength of the driver is a function of the distance between the driver and the one of a processing unit, a routing section or a functional block.

8. The programmable logic device of any of claims 3 to 7, wherein the multi-bit buses are four-bit buses.
